# EUROPEAN PATENT APPLICATION

(11) **EP 0 729 231 A2**
(43) Date of publication of application: **28.08.1996**
(21) Application number: 96102656.4
(22) Date of filing: 22.02.1996
(51) Int. Cl.: H03K 5/13

(54) **Voltage-controlled delay unit for delay-locked loop devices**

(30) Priority: 23.02.1995 IT TO950130
(71) Applicant: CSELT Centro Studi e Laboratori Telecomunicazioni S.p.A., I-10148 Turin (IT)
(72) Inventor: Torielli, Alessandro, Torino (IT)
(74) Representative: Riederer Freiherr von Paar zu Schönau, Anton

(57) **Abstract**

The delay unit (UR) comprises one or more stages (R1...Rn) each including a chain of inverters (IN1...IN4). A capacitive load is applied to the output node of each inverter. That load is made to vary by a voltage control signal and is made up by the gate capacitance of a P transistor (Tp1...Tp4).

## Description

The invention described herein relates to interconnections between elements of switching systems for high-speed telecommunications networks, e.g. ATM networks, and in particular it concerns a voltage-controlled delay unit for delay-locked loops to be utilised at the receiving side of an interconnection line over which a serial signal transmission takes place.

A commonly adopted technique for interconnection between the different elements within ATM switching stages, or in general between the different parts of a system belonging to a high-speed telecommunications network, entails transferring the data with a 4 or 8 bit parallelism, and thus using lines with 4 or 8 wires, which can be associated with a wire for cell synchronism and a wire for the clock signal. As the size of the stages increases, serious problems arise with regard to the number of these interconnections (and therefore to the cost of the wires and the size of the connectors), the power consumption to drive them, the distances over which the signals must travel, the noise, etcetera. Thus, there is an interest in accomplishing data transfer over these interconnection serially, to reduce the number and the size of the wires and connectors. Serial interconnections can be advantageously made of optical fibres, which are intrinsically immune from electromagnetic noises and require smaller powers for a same distance, given their low attenuation.

When serial interconnections, be they optical or electric, are used, the clock signals for sampling the data, possibly reconverted into electrical form, can be recovered from the same data flow or can be derived from signals supplied by a local generator. In the latter case, the problem of the alignment between data and clock signals is particularly serious, given the high speeds involved (for instance, one can recall that a transmission with 4-bit parallelism over one of such interconnections occurs at a rate of the order of eighty Mbit/s, and therefore the corresponding serial transmission shall occur at a rate exceeding 300 Mbit/s). A solution to this problem is represented by the use of the so-called delay-locked loops: there, data are made to go through a variable-delay unit which introduces, on the data, a delay determined by a control signal obtained by comparing the phase of the data with that of a local clock signal in a phase detector.

The paper "A PLL Clock Generator with 5 to 110 MHz of Lock Range for Microprocessors", by I. A. Young, J. K. Greason and K. L. Wong, IEEE Journal of Solid State Circuits, Vol. 27, No. 11, November 1992, describes a voltage controlled variable delay unit for a phase-locked loop; the unit is composed of a single inverter of which the output is connected with a capacitive load which is varied by the control signal through an N-type transistor. A unit of this kind can also be utilised in delay-locked loops. To obtain the delay variations indicated above with a single element, the capacitive load must be very high and for that reason it is generally made up of a metal area of the integrated circuit into which the loop is inserted. The driving transistor also must be large. Moreover, this solution presents the drawback of causing data distortions, as the control transistor-capacitance structure is not linear and therefore it acts in a asymmetric way on transitions 0 → 1 and 1 → 0, which have different durations.

According to the invention, a delay unit is instead provided which does not require the use of large components and does not introduce appreciable distortions.

Such unit is made up of one or more cells each comprising a chain of inverters, arranged along the path of a data signal to be synchronised, and the output of each inverter is connected to a variable capacitive load, of limited value, through means for receiving the control signal and modulating the capacitive load.

Advantageously, the capacitive load is made up of the gate capacitance of a P-type transistor.

For the sake of greater clarity, reference is made to the enclosed drawings, where:
- figure 1 is the block diagram of a delay-locked loop;
- figure 2 is the block diagram of the delay unit; and
- figure 3 is the schematic circuit diagram of a cell of the delay unit.

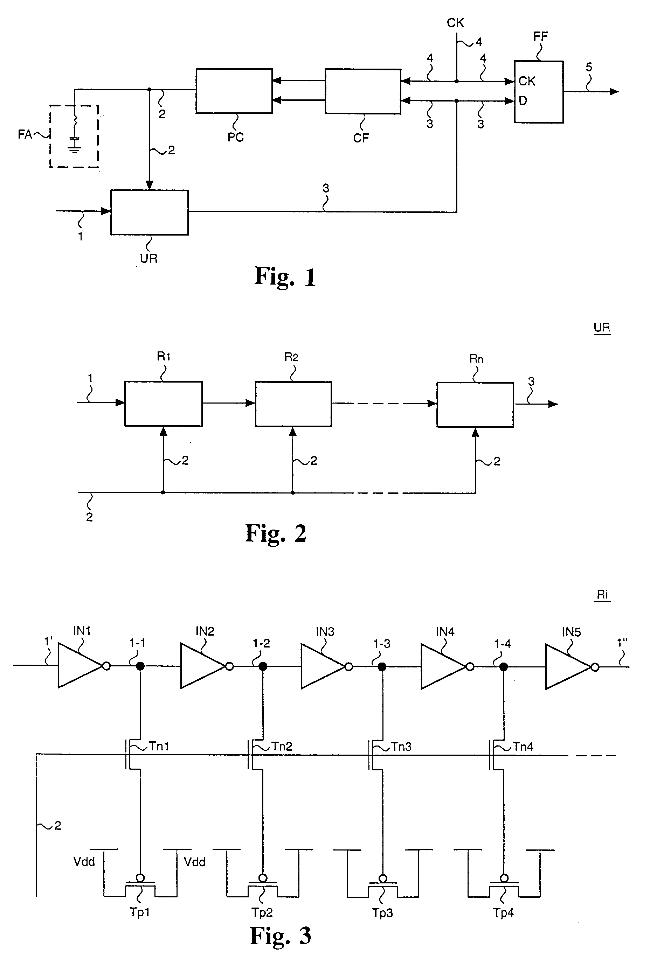

Figure 1 shows the schematic circuit diagram of a delay-locked loop. By way of example, it is assumed that this loop is employed in a data parallelisation circuit at the end of an optical interconnection line between elements of an ATM cross-connect, in order to synchronise with a 320 MHz clock signal CK a 320 Mbit/s data stream, resulting from the serialisation of a stream of ATM cells at 80 Mbit/s with 4-bit parallelism.

The data to be sampled, present on a line 1, are received by a voltage-controlled delay unit UR, able to introduce a delay r±Δr on the signals. In the application indicated above, Δr can be on the order of 5 ns. To generate the control signal for UR, present on a wire 2, the data signal leaving UR on wire 3 and clock signal CK, present on a wire 4, are supplied to a phase detector CF, e.g. a detector of the type described by C. R. Hogge in the paper "A Self Correcting Clock Recovery Circuit", Journal of Lightwave Technology, Vol. LT-3, No. 6, pp. 1312-1314, December 1985. Phase detector CF presents a pair of outputs on which signals representing the entity of a possible lead or lag of the data are present. These signals drive a current pump PC which consequently emits pulses that increase or decrease the charge of a capacitor in a loop filter FA (in particular a RC circuit). The filtered signal constitutes the control signal. Output 3 of UR and wire 4 are then connected to the data and clock inputs of a sampling device (represented by flip-flop FF) which emits on output 5 the synchronised data.

As can be seen in Figure 2, delay unit UR comprises a number of identical elementary cells R1...Rn, which are all controlled by the signal present on wire 2 and have the structure indicated in Figure 3. The generic cell Ri comprises a chain of identical elements (four in the example shown in the figure). Each element is made up of: an inverter IN1 (and respectively IN2, IN3, IN4), which receives the data signal to be delayed from input 1' of the cell (or respectively from output 1-1, 1-2, 1-3 of the preceding inverter); a P-type transistor, Tp1...Tp4, whose gate capacitance represents a variable capacitive load applied to the output of the respective inverter; and an N-type transistor, Tn1...Tn4, which is inserted between the output of inverter IN1...IN4 and the gate of transistor Tp1...Tp4 and receives at the gate electrode the control signal present on wire 2. The other electrodes of the transistors Tp1...Tp4 are connected, for instance, to voltage V_{dd}, as indicated for Tp1.

It is clear that the variation of the control signal causes a variation of the gate capacitance of transistors Tp and therefore a variation of the delay introduced by the chain of inverters. Output 1-4 of inverter IN4 of the last element in the chain is connected to the input of an additional inverter IN5, not associated to any load, whose output 1'' is the output of the cell.

A modular delay unit like the one described above clearly allows to utilise smaller components to obtain the desired effect. Moreover, the presence of the chain of inverters inside each cell renders essentially symmetrical the action of the N-type transistors and of the capacitances on the transitions, which are reversed at each element. The output inverter of each individual cells has the same effect. The overall distortion introduced is therefore minimal. Finally, using the gate capacitance of a P-type transistor as a capacitive load yields the advantage that the desired load can be obtained by occupying a minimal area, since, as is well known, P transistors have the highest capacitance per unit area.

The overall number of elements in a cell and the overall number of cells depend on the overall delay to be introduced and on the requirements for the manufacture, as an integrated circuit, of the device in which the delay-locked loop is to be utilised. Obviously, the number of cells and of elements per cell shall be such as to comprise an even number of inverters. In the application of unit UR in the example indicated above, eight cells with four elements each, to compensate phase differences of ± 5ns, were utilised. A similar configuration has allowed the manufacture of the unit on a pad of an integrated circuit for the serialisation/parallelisation of the ATM stream. The realisation on a pad yields the additional advantage that power supplies on the edge can be exploited: as is well known, they are the most stable and noise-free ones.

## Claims

1. Delay unit for delay-locked loop devices, for the introduction, on a data signal, of a delay whose magnitude can be varied by a control signal, characterised in that it comprises at least one cell (R1...Rn) comprising a chain of inverters (IN1...IN4), arranged along the path of the data signal, the output of each inverter being connected to a variable capacitive load (Tp1...Tp4), of such a value that no data signal distortion is introduced, through means (Tn1...Tn4) arranged to receive the control signal and to modulate the capacitive load.

2. Unit as claimed in claim 1, characterised in that it comprises a plurality of cells (R1...Rn).

3. Unit as claimed in claim 1 or 2, characterised in that the capacitive load connected to the output of each inverter (IN1...IN4) is made up of the gate capacitance of a P-type transistor (Tp1...Tp4), and the means to modulate the load are made up of an N-type transistor (Tn1...Tn4) which is connected between the output of the inverter (IN1...IN4) and the gate of the P-type transistor (Tp1...Tp4) and receives the control signal at the gate electrode.

4. Unit as claimed in any of the previous claims, characterised in that the or each cell (R1...Rn) also comprises an additional inverter (IN5), downstream of the chain of inverters (IN1...IN4), to transfer data to the subsequent cell or to the output of the unit.

5. Unit as claimed in any of the previous claims, characterised in that it is realised on a pad of an integrated circuit.
